(19) Europäisches Patentamt

European Patent Office

Office européen des brevets

(11) Publication number: **0 464 853 A2**

# EUROPEAN PATENT APPLICATION

(21) Application number: **91111311.6**

(22) Date of filing: **08.07.91**

(51) Int. Cl.⁵: **H03J 7/28**, H03J 7/06

(30) Priority: **06.07.90 GB 9014937**

(43) Date of publication of application:
**08.01.92 Bulletin 92/02**

(84) Designated Contracting States:
**AT BE CH DE DK ES FR GB GR IT LI LU NL SE**

(71) Applicant: **HI-TRAK SYSTEMS LIMITED**
**P.O. Box 72**
**Horley, Surrey RH6 0YN(GB)**

(72) Inventor: **van der Veen, Albertus Carel**
**11 Stuart Close**
**Hextable, Kent(GB)**

(74) Representative: **Spence, Anne et al**
**Fry, Heath & Spence Mill House Wandle**
**Road**
**Beddington Croydon Surrey CR0 4SD(GB)**

(54) **Radio receiving system.**

(57) The invention concerns a radio receiving system designed to receive selectively signals from a series of transmitters transmitting at frequencies each in a very narrow frequency band and each separated from the other transmitters by only a small increment of frequency. Such receiving systems are useful for picking up signals from transmitters carried by falcons or other hunting birds. The system comprises a receiving circuit (12), a memory (22, 24) programmed with data representing a set of receiving channels at predetermined frequencies, preferably around 216 MHz, selector means (26) for selecting a channel of the set, tuning means (20, 23) for fine tuning the frequency of a selected channel, electrically programmable memory means (22, 25) for recording fine tuning data relating to each channel, adjusted frequency signal generating means (17) for generating an adjusted frequency signal dependent on the preprogrammed data and the fine tuning data relating to each channel when that channel is selected by the selecting means, and means (15, 16) for using the adjusted frequency signal to control the receiving circuit.

## Background of the Invention

This invention relates to a Radio Receiving System designed to receive selectively signals from a plurality of transmitters transmitting at frequencies each in a very narrow frequency band and each separated from the other transmitters by only a small increment of frequency compared with the basic transmitted frequency. The receiving system, together with a directional antenna, is particularly concerned with picking up signals from transmitters carried by falcons or other hunting birds and in indicating the direction from where the signal is coming. However, the receiving system could be useful for receiving signals from transmitters carried by people, other animals or objects.

In the sport of falconry, a transmitter is attached to a bird so that it is possible for the falconer to monitor the position of the bird when it is out of sight or on the ground. A group of falconers may have as many as a hundred birds flying simultaneously using transmitters transmitting at frequencies which are separated from one another by only small increments and it is desirable to be able to monitor each of these birds using only a single receiver.

The frequencies for this sport are designated in each country in which it is practiced. In the UK the legal frequency granted by the Government is approximately 173 to 174 MHz. In USA, Canada, and Europe the frequency alloted for falconry is approximately 216 MHz. In Germany frequencies of 151 to 155 MHz and 403 to 405 MHz are also used. For other purposes other frequencies in the VHF range (30 to 300 MHz) might be used. In the middle East frequencies in the range 215-220 MHz are used.

A falconer might for example have a set of one hundred transmitters each operating in the range 215-220 MHz each fixed at a frequency which differs from others in the set by increments of 50 KHz and each transmitting at its fixed frequency plus the tolerance of the crystal used in each transmitter. This tolerance will normally be in the range of 10-30 parts per million, which, at 216 MHz, represents 2160-6480 Hertz. The receiver needs a set of channels tuned to the set of transmitters and means for selecting a particular channel so as to receive from a particular selected transmitter as desired.

The signal from the transmitter is normally a pulsed carrier wave and the receiver reduces this down to produce a pulsed audiotone. The audio bandwidth is made narrow in the order of 1000 Hz, so as to produce a reasonable signal to noise ratio - sensitivity. It will be appreciated that in order to centre the received signal in the audio passband of the receiver, and to produce an audio tone that is approximately the same for each transmitter, it is necessary to precisely tune each channel specifically to the associated transmitter - in order of better than 100 Hz accuracy since the peak signal condition is only about 200 Hz wide. Thus each channel of the receiver needs to be able to be individually tunable over a range of about ± 6500Hertz in increments of preferably no more than 100 Hz in order to tune out the maximum frequency variation of the transmitter.

## PRIOR ART

Known receivers for use in falconry either have a separate tuning control for each channel which very much restricts the number of channels which can be incorporated in the single receiver or have a single "Fine Tune" control which requires retuning as each channel is reselected or have a single tuning knob which tunes over the frequency band and must be adjusted each time the falconer wants to select a new transmitter. It will be appreciated that it is extremely difficult to locate and tune to a transmitter (which is only giving a pulsed output) when it is not known exactly what the actual transmission frequency is or the direction of the transmitter, especially when the received signal is very weak.

An object of the present invention is to provide a receiver system capable of receiving on a plurality of channels and which allows each channel to be easily and accurately tuned to a transmitter frequency and which tuning is remembered and easily recallable.

While a receiver is known, particularly for use as a car radio, which can receive a plurality of channels, can be tuned to different frequencies corresponding to the different channels and has a memory and recall system so that a pretuned frequency can be recalled from memory, normally by a push button selector, the accuracy required is of a completely different order and the memory has no permanently fixed tuning information and no fine tuning system. The memory is normally erased if the radio is disconnected from the car battery.

Circuits are also known for tuning television receivers to correct for component tolerances. For example GB Patent Specification 2048002 has a fine tuning system in which a divider M is varied by one or two in order to fine tune a synthesizer. However this gives a far too coarse adjustment for the receivers with which this invention is concerned. In the example given the minimum fine tune increment is 80 KHz (for M becoming M + 1).

Other specifications relating to frequency adjustment of television include GB 2105935, US 4173737 and EP 0030329 and 0147518. However none of these adjusts a reference frequency generated by a crystal controlled oscillator or is capable of achieving the necessary small increment adjustment achieved by the present invention. Television fine tuning is generally in increments of the order of tens of KiloHertz. If the reference frequency in such systems is reduced to a lower enough frequency to give small increments the speed with which the system will stabilise reduces unacceptably.

## SUMMARY OF THE INVENTION

The present invention provides a radio signal receiving system comprising;

a receiving circuit,

a memory programmed with data representing a set of receiving channels at predetermined frequencies,

selector means for selecting a channel of the set,

tuning means for fine tuning the reference frequency of a frequency synthesizer and therefore the frequency of a selected channel,

electrically programmable memory means for recording fine tuning data relating to each channel, and

adjusted frequency signal generator means for generating an adjusted frequency signal dependent on the preprogrammed data and the fine tuning data relating to each channel when that channel is selected by the selector means, and

means for using the adjusted frequency signal to control the receiving circuit.

With such a system the frequencies are easily selected and fine tuned using a single tuning means and the accurately fine tuned frequencies for each channel can be easily recalled using the selector means and used to tune the receiving means to receive maximum signal at that adjusted frequency.

The fine tuning data is preferably supplied to a voltage controlled crystal oscillator to provide a small variation of the reference frequency signal proportional to the fine tuning data. The fine tuning control includes a variable voltage generating device.

The fine tuning data can preferably adjust the reference frequency in increments no greater than 100 Hz, with advantage about 50 Hz. The variable voltage is preferably supplied to the EEPROM through an analogue to digital converter as an 8 bit piece of data information. After initial tuning, when the channel is reselected, the stored information is used to control the crystal oscillator circuit after being passed through a digital to analogue converter.

A synthesizer is used to combine the data from the ROM and the reference frequency signal representing the fine tuning data and to provide a local oscillator signal representing the adjusted frequency for controlling the receiving circuit.

In a preferred form the receiving circuit is set to receive at a fixed intermediate frequency from a mixer unit which receives both the local oscillator signal and the signal to be tracked from a transmitter and supplies the difference of these signal to the receiving circuit.

## DETAILED DESCRIPTION OF ONE EMBODIMENT

One embodiment of receiving system in accordance with the invention will now be described, by way of example only, with reference to the accompanying block circuit diagram.

The receiving system comprises a receiver circuit 12 designed to receive at a fixed intermediate reception frequency and to provide an output audio or other signal at 12A which preferably includes a directional antenna. The intermediate reception signal is at a frequency between the received signal at 216 MHz nominal and the audio signal to be emitted. In this example the intermediate frequency is at 10.695 MHz.

The incoming signal to be tracked from a transmitter in the VHF range (in this example at 216 MHz nominal) is received by an antenna 13 connected to the receiver circuit via a radio frequency amplifier 14 and a mixer unit 15. The mixer unit also receives a local oscillator signal on line 16 at 205.305 MHz nominal so that the receiver always receives the signal at 10.695 MHz. The mixer is thus giving a frequency which is the difference between the frequency from the antenna 13 and the local oscillator signal frequency.

The local oscillator signal is derived in a synthesiser 17 from a reference frequency signal 18 from a voltage controlled crystal oscillator circuit 20 and channel data on line 21 from the memory 22 (of a microprocessor).

The crystal oscillator circuit 20 has a basic frequency of 10.240 MHz which is variable by a factor of ± 6500 Hz determined by a tuning variable voltage supply 23. The reference frequency is divided by 1000.24 in the synthesizer to 10 KHz which allows a fast stabilising speed within the the the synthesizer.

The memory 22 includes a chip preprogrammed with read only memory (ROM) data representing a plurality of preselected frequencies corresponding to the required set of reception channel frequencies. The memory also includes erasable electrically programmable memory means (EEPROM) for recording fine tuning information relating to each channel. The memory has an output port 24 for transmitting to the synthesizer 17 the preprogrammed data information relating to the basic channel frequency data on lines 21. The memory has an input/output port 25 for receiving and transmitting the EEPROM data. Selector means 26 is provided for selecting the data of a particular channel and causing that data to be transmitted on both ports 24 and 25. In the present example there are one hundred selectable channels and the selector means 26 comprises two selection and display members for selecting respectively tens and units so that any channel from 0 to 99 can be selected rapidly and the selected channel displayed. If the nominal frequency of the transmitter is 216 MHz, then each channel and transmitter in a set may be tuned at a frequency varying from other frequencies in increments of 50 KHz so the first channel will be at 216.000 MHz the second 216.050 MHz, the third at 216.100 MHz, the fourth at 216.150 MHz etc. The fine tuning allows adjustments of at least up to plus or minus thirty parts per million.

The output from the tuning voltage device 23 is connected via a manual on/off switch 28 to the reference frequency generator circuit 20 and via an analogue to digital converter 29 under the control of a store switch device 30 to the port 25. The store switch 30 is also connected to memory 22 so as to give the required READ/WRITE instruction. The port 25 is also connected via a digital to analogue converter 31 and an on/off auto switch 32 to the reference frequency generator circuit 20.

The circuit is powered from a power supply unit 33, giving 5 volts and 9 volts as shown from a car battery or battery pack 34.

In order to tune the receiving system for use with a set of transmitters, having output frequencies substantially at the preselected nominal frequencies of the channels which the ROM memory data represents, the channel selector means is set to the first channel corresponding to the first transmitter, the transmitter is switched on, the manual on/off switch 28 is closed and auto switch 32 opened and the tuning voltage device 23 is adjusted to achieve maximum signal at the receiving circuit 12. The store switch 30 is operated causing the tuning voltage signal to be converted to an 8 bit piece of data and supplied to the port 25 where it is recorded in the EEPROM associated with that channel. The fine tuning from variation diode 23 is 0 to 5 volts. The analogue to digital converter stores the voltage as an eight bit word with 00000000 equal to 0 volts and 11111111 equal to 5 volts giving 255 possible variants. The crystal oscillator is variable by ± 6500 Hz, hence the frequency increments by which the reference frequency can be varied equal

$$\frac{13000 \ Hz}{255} = 51Hz.$$

The process is repeated for all transmitters and channels which it is required to use.

The store switch 30 is then switched so that the port 25 is an output port arranged to supply the 8 data bits of information representing voltage to the digital to analogue converter 31, the auto switch 32 is closed and the manual switch 28 is opened. When a channel is now selected the synthesizer receives information both corresponding to the basic frequency of the selected channel from the ROM and information corresponding to the fine tuning data from the EEPROM via the digital to analogue converter 31 which provides the fine tuning voltage to the reference frequency generator circuit 20. The synthesizer then produces a local oscillator signal at an adjusted frequency based on the preprogrammed channel frequency together with the fine tuning adjustment which varies from the transmitter signal corresponding to the selected channel by exactly the IF reception frequency giving a maximum signal at the receiver circuit.

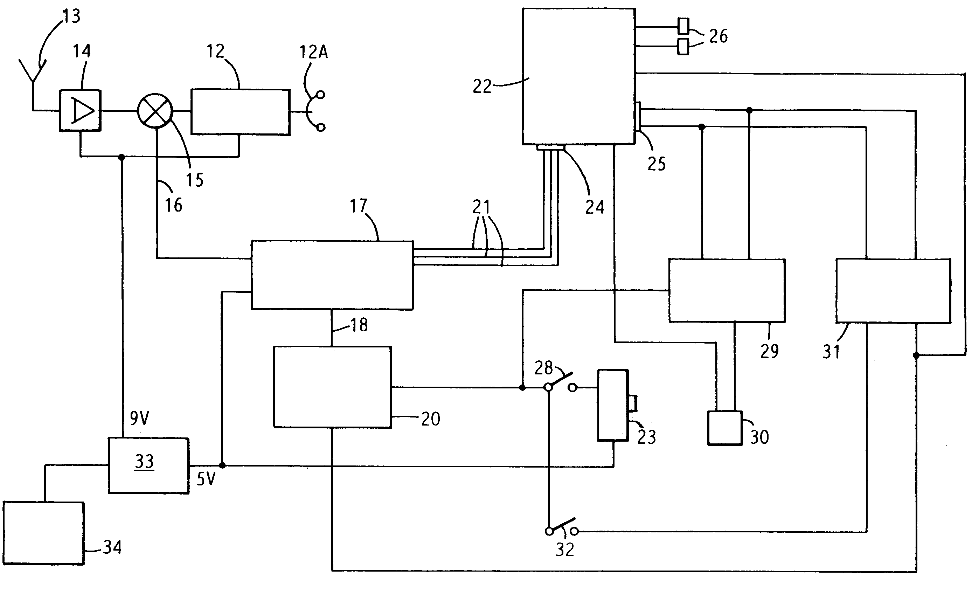

**Claims**

1.  A radio signal receiving system comprising:
    a receiving circuit (12), a memory (22) programmed with data representing a set of receiving channels at predetermined frequencies, selector means (26) for selecting a channel of the set, fine tuning means (20, 23-32) for fine tuning the frequency of a selected channel, electrically programmable memory means (22) for recording fine tuning data relating to each channel, adjusted frequency signal generating means including a frequency synthesizer (17) for generating an adjusted frequency signal (16) dependent on both the preprogrammed data and the fine tuning data relating to each channel when that channel is selected by the selector means, and means for using the adjusted frequency signal to control the receiving circuit characterised in that the fine tuning means includes a crystal controlled oscillator (20) which is arranged to provide a variable reference frequency signal (18) to the synthesizer (17), such reference frequency being variable by the fine tuning data.

2.  A receiving system according to claim 1 characterised in that the fine tuning means includes a variable voltage generating device (23) arranged to supply variable voltage to the voltage controlled crystal oscillator (20) to provide a fine tuning reference frequency signal (18) and in that the fine tuning data represents the variable voltage.

3.   A receiving system according to claim 1 or claim 2 characterised in that the fine tuning means is arranged to vary the reference frequency in increments of no more than 100Hz.

4.   A receiving system according to claim 3 characterised in that the fine tuning means is arranged to vary the reference frequency in increments of substantially 50Hz.

5.   A receiving system according to any of claims 1 to 4 characterised in that the fine tuning data is supplied to the electrically programmable memory means (22) via an analogue to digital converter (29) as an 8 bit piece of data information and the fine tuning data is supplied to the crystal oscillator (20) from the electrically programmable memory means through a digital to analogue converter (31).

6.   A receiving system according to any of claims 1 to 5 in which the receiving circuit is set to receive at a fixed intermediate frequency.

7.   A receiving system according to claim 6 in which the intermediate frequency is in the range 10.6 to 10.8 MHz.

8.   A receiving system according to claim 6 or claim 7 including a mixer unit (15) arranged to receive both the local oscillator signal (16) and the signal (13) to be tracked from a transmitter and to supply the difference of these signals to the receiving circuit (12).

9.   A receiving system according to any of claims 1 to 8 in which the signal (13) from the transmitter is a pulsed carrier wave and the receiving circuit (12) is arranged to reduce this to produce a pulsed audio tone.

10.  A receiving system according to any of claims 1 to 9 in which the receiving channels have frequencies which vary from one another by small increments, no more than 150 KHz.

11.  A receiving system according to any of claims 1 to 10 in which the band width of each channel is less than 2,000 Hz preferably approximately 1000 Hz.

12.  A receiving system according to any of claims 1 to 11 in which each channel is finely tunable over a range within ± 7000 Hz.

EP 0 464 853 A2